# EUROPÄISCHE PATENTANMELDUNG

(11) **EP 4 064 804 A1**
(43) Veröffentlichungstag der Anmeldung: **28.09.2022**
(21) Anmeldenummer: 22164551.8
(22) Anmeldetag: 25.03.2022
(51) Int. Cl.: H05K 3/32, H05K 3/40

(54) **ELEKTRONISCHES BAUELEMENT UND VERFAHREN ZUR HERSTELLUNG EINES ELEKTRONISCHEN BAUELEMENTS**

(30) Priorität: 26.03.2021 DE 102021203076
(71) Anmelder: Fraunhofer-Gesellschaft zur Förderung der angewandten Forschung e.V., 80686 München (DE)
(72) Erfinder: HOENE, Eckart, 13355 Berlin (DE); ERHARDT, Eugen, 13355 Berlin (DE)
(74) Vertreter: Pfenning, Meinig & Partner mbB

(57) **Zusammenfassung**

Die vorliegende Anmeldung liegt auf dem Gebiet der elektrischen Verbindungstechnik. Die Anmeldung betrifft ein elektronisches Bauelement (1) und ein Verfahren zur Herstellung eines elektronischen Bauelements (1). Das vorgeschlagene elektronische Bauelement (1) umfasst ein erstes Bauteil (3) und ein zweites Bauteil (4). Außerdem umfasst das elektronische Bauelement (1) eine Litze (5), die mit einer Kontaktstelle des zweiten Bauteils (4) verbunden ist. Außerdem ist die Litze (4) mit einer Kontaktstelle des ersten Bauteils (3) laserverschweißt und/oder laserverlötet.

## Beschreibung

Die vorliegende Anmeldung liegt auf dem Gebiet der elektrischen Verbindungstechnik. Die Anmeldung betrifft ein elektronisches Bauelement und ein Verfahren zur Herstellung eines elektronischen Bauelements.

Elektronische Bauelemente, die ein erstes Bauteil und ein zweites Bauteil aufweisen, die elektrisch und mechanisch miteinander verbunden sind, sind bekannt. Beispielsweise werden bei der Herstellung von Leistungsmodulen, insbesondere zum Anschluss von Leistungshalbleitern, verschiedene Verbindungstechniken eingesetzt. Vorteilhaft ist hierbei, wenn die Art der Verbindung einen hohen Stromfluss erlaubt, niederinduktiv ist und eine thermomechanische Entkopplung ermöglicht, wobei die meisten bekannten Verbindungsarten diese Voraussetzungen für gewisse Anwendungen nur unzureichend gewährleisten. Insbesondere kann eine thermomechanische Ermüdung von Verbindungstechnik aufgrund von unterschiedlichen Ausdehnungskoeffizienten der verwendeten Materialien ein lebensdauerbegrenzendes Problem darstellen.

Demgegenüber ist es eine Aufgabe der vorliegenden Anmeldung ein verbessertes elektronisches Bauelement vorzuschlagen. Insbesondere ist es eine Aufgabe der vorliegenden Anmeldung, ein elektronisches Bauelement vorzuschlagen, das eine zuverlässige Verbindung ermöglicht, die haltbar und gleichzeitig vergleichsweise einfach herstellbar ist. Darüber hinaus ist es eine Aufgabe der vorliegenden Anmeldung ein entsprechend vorteilhaftes Verfahren zur Herstellung eines elektronischen Bauelements vorzuschlagen.

Diese Aufgaben werden gelöst durch ein elektronisches Bauelement mit den Merkmalen des Anspruchs 1 sowie durch ein Verfahren zur Herstellung eines elektronischen Bauelements mit den Merkmalen eines nebengeordneten Anspruchs. Vorteilhafte Weiterbildungen ergeben sich mit den Merkmalen der abhängigen Ansprüche und der Ausführungsbeispiele.

Das vorgeschlagene elektronische Bauelement umfasst ein erstes Bauteil und ein zweites Bauteil. Außerdem umfasst das elektronische Bauelement eine Litze, die mit einer Kontaktstelle des zweiten Bauteils verbunden ist. Außerdem ist die Litze mit einer Kontaktstelle des ersten Bauteils laserverschweißt und/oder laserverlötet.

Durch die Verwendung einer laserverschweißten bzw. laserverlöteten Litze wird ein hinreichend großer Leitungsquerschnitt bereitgestellt, sodass das vorgeschlagene elektronische Bauelement einen hinreichend großen Stromfluss zwischen dem ersten Bauteil und dem zweiten Bauteil gewährleistet. Zudem wird durch die Litze in der Regel eine bewegliche und zugleich haltbare Verbindung zwischen dem ersten Bauteil und dem zweiten Bauteil erreicht. Indem die Litze zudem laserverschweißt und/oder laserverlötet ist, ist diese zur Herstellung einer zuverlässigen Verbindung mit unterschiedlichen aus der elektrischen Verbindungstechnik bekannten Bauteilmaterialien und Bauteilgeometrien geeignet, wobei in vielen Fällen keine spezielle Vorbehandlung nötig ist. Der Verbindungsprozess kann somit basierend auf etablierten Prozessen und Bauteiltypen, insbesondere automatisiert, durchgeführt werden. Hierbei kann sich zu Nutze gemacht werden, dass das Laserverschweißen bzw. Laserverlöten der Litze mit der Kontaktstelle des ersten Bauteils sehr kontrollierbar bei vergleichbar geringem Platzbedarf und anpassbar an verschiedenartige zu verbindende Bauteile anpassbar einsetzen lässt. Beispielsweise kann durch kontrolliertes Laserverschweißen bzw. Laserverlöten eine zuverlässige Verbindung auch mit empfindlichen Kontaktmaterialien und Kontaktgeometrien erreicht werden.

Entsprechend vorteilhaft ist ein Verfahren zur Herstellung eines elektronischen Bauelements, insbesondere des oben oder unten im Detail beschriebenen elektronischen Bauelements. Bei dem Verfahren wird ein erstes Bauteil des elektronischen Bauelements mit einem zweiten Bauteil des elektronischen Bauelements verbunden. Bei dem Verfahren werden das erste Bauteil und das zweite Bauteil bereitgestellt. Außerdem wird eine Litze bereitgestellt. In einem weiteren Schritt wird die Litze mit einer Kontaktstelle des zweiten Bauteils verbunden, insbesondere elektrisch leitfähig verbunden. Vorher oder anschließend wird die Litze mit einer Kontaktstelle des ersten Bauteils durch Bestrahlung der Litze mit einem Laser derart laserverschweißt oder laserverlötet, dass eine elektrisch leitfähige Verbindung zwischen der Litze und dem ersten Bauteil erzeugt wird.

Beim Verbinden der Litze mit dem ersten und/oder zweiten Bauteil wird in der Regel auch eine mechanisch haltbare Verbindung zwischen dem ersten bzw. zweiten Bauteil und der Litze erzeugt. Durch das Laserverschweißen bzw. Laserverlöten kann eine direkte Verbindung zwischen der Litze und der Kontaktstelle des ersten bzw. zweiten Bauteils erzeugt werden. Die Litze kann mit der Kontaktstelle des ersten Bauteils und/oder der Kontaktstelle des zweiten Bauteils stoffschlüssig verbunden sein. In typischen Ausführungen werden die Kontaktstellen des ersten Bauteils und des zweiten Bauteils durch das Laserverschweißen bzw. Laserverlöten dauerhaft elektrisch Leitfähig miteinander verbunden.

Das erste Bauteil und/oder das zweite Bauteil ist in der Regel ein elektronisches Bauteil. Das erste Bauteil und/oder das zweite Bauteil weist zudem in der Regel elektronische Schaltkreise auf. Die elektronischen Schaltkreise können leitend mit der Kontaktstelle verbunden sein, sodass durch die Litze ein elektrischer Kontakt zum Schaltkreis hergestellt werden kann. Das elektronische Bauelement kann eine Halbleiteranordnung sein, die beispielsweise zumindest einen Halbleiterchip umfasst. In typischen Ausführungen ist das elektronische Bauelement ein Leistungsmodul. Hierbei kommen die Vorteile der laserverschweißten bzw. laserverlöteten Litze besonders zum Tragen. Beispielsweise kann das erste Bauteil und/oder das zweite Bauteil ein Leistungshalbleiter sein.

In typischen Ausführungen erfolgt das Verbinden der Litze mit einer Kontaktstelle des zweiten Bauteils durch Laserverschweißen und/oder Laserverlöten der Litze mit der Kontaktstelle des zweiten Bauteils durch Bestrahlung der Litze mit einem Laser derart, dass eine elektrisch leitfähige Verbindung zwischen der Litze und dem zweiten Bauteil erzeugt wird. Typischerweise ist die Litze somit mit der Kontaktstelle des zweiten Bauteils ebenfalls laserverschweißt bzw. laserverlötet. Beim Verbinden der Litze mit dem ersten Bauteil und mit dem zweiten Bauteil kann derselbe Laser oder ein anderer Laser zum Einsatz kommen.

In typischen Ausführungen ist die Litze ein Flachband. Die Litze kann insbesondere als Bändchen mit flachem und breitem Querschnitt ausgebildet sein. Die Litze ist in der Regel so mit der Kontaktstelle des ersten und/oder des zweiten Bauteils verbunden, dass die Litze mit einer flachen Oberseite oder flachen Unterseite auf der Kontaktstelle aufliegt. Durch Verwendung eines Flachbandes lässt sich ein Wärmeeintrag beim Laserverschweißen bzw. Laserverlöten in zuverlässiger Weise bereitstellen und es kann zudem eine zuverlässig elektrisch leitende und mechanisch haltbare Verbindung erzeugt werden.

Die Litze weist in der Regel metallische Einzeladern auf. In typischen Ausführungen umfasst die Litze zumindest eine Einzelader, insbesondere zumindest zwei oder 10 Einzeladern und/oder höchstens 10000 Einzeladern. In typischen Ausführungen beträgt eine Querschnittsfläche der Litze zumindest 0,1 mm² und/oder höchstens 100 mm². Eine Breite der Litze beträgt in der Regel zumindest 0,2 mm und/oder höchstens 50 mm. Eine Länge der Litze kann in einigen beispielhaften Ausführungen höchstens 100 mm, insbesondere höchstens 50 mm, betragen. Eine Höhe der Litze kann zumindest 0,1 mm und/oder höchstens 2 mm betragen. Eine Querschnittsfläche der Einzeladern kann in typischen Ausführungen zumindest 0,01 mm² und/oder höchstens 10 mm² betragen. Die einzelnen Einzeladern weisen in der Regel im Wesentlichen Querschnittsflächen derselben Größe auf. Die Einzeladern haben in der Regel einen im Wesentlichen runden Querschnitt. Eine Ausführung mit Einzellitzen, insbesondere in den oben angegebenen Abmessungen, ist von Vorteil, da hierbei die vergleichsweise feinen Einzeladern eine verbesserte Absorption eines Laserstrahls des Lasers bewirken können. Hierbei kann der Laserstrahl zwischen den Einzeladern in die Litze eindringen und insbesondere intern mehrfach reflektiert und teilabsorbiert werden.

In einigen Ausführungen ist die Litze eine Kupferlitze. Beispielsweise kann es vorgesehen sein, dass die Einzeladern Kupfer enthalten oder aus Kupfer hergestellt sind. Die Einzeladern sind in einigen Ausführungen geflochten ausgeführt. Es kann auch vorgesehen sein, dass die Litze bereits vor Herstellung der Verbindung mit den Bauteilen vorverdichtet, insbesondere gewalzt, ist.

Durch Betrachtung der Verbindungen zwischen der Litze und den Kontaktstellen ist für einen Fachmann erkennbar, dass die Litze durch Laserverschweißen bzw. Laserverlöten und nicht durch ein anderes Verfahren mit der Kontaktstelle verbunden wurde. Hierbei ergeben sich durch Verwendung eines Lasers vergleichsweise wohldefinierte und kleinflächige Verbindungsstellen. In typischen Ausführungen sind die metallischen Einzeladern laserverschweißt und/oder laserverlötet. Die Einzeladern werden hierbei insbesondere im selben Schritt laserverschweißt bzw. laserverlötet, in dem die Herstellung der Litze mit dem Bauteil erzeugt wird. Somit ergibt sich in der Regel eine charakteristische Verschweißung und/oder Verlötung der Einzeladern der Litze infolge der Herstellung der Verbindung zwischen Litze und Bauteil durch Laserverschweißen und/oder Laserverlöten. Diese Verschweißung bzw. Verlötung tritt in der Regel in der Litze im Bereich der Kontaktstelle mit dem Bauteil auf. Mischformen zwischen einer Laserverschweißung und Laserverlötung sind hierbei auch möglich. In der Regel ist die Litze durch das Laserverschweißen bzw. Laserverlöten zu einem gewissen Grad verdichtet. Die bei der Verschweißung bzw. Verlötung mittels Laser auftretenden Schweiß- bzw. Lötstellen sind in der Regel deutlich kleiner als jene, die bei aus dem Stand der Technik bekannten schweiß- bzw. lötverfahren an einer Litze auftreten würden. Insbesondere kann eine durch das Laserverschweißen bzw. Laserverlöten hervorgerufene Schweiß- bzw. Lötstelle auf der Litze eine Breite von weniger als 1 mm, insbesondere weniger als 0,5 mm oder weniger als 200 µm aufweisen. Dies bringt auch den Vorteil mit sich, dass durch die kleinen Schweiß- bzw. Lötstellen ein größerer Anteil der Litze biegsam bleibt, wodurch robustere Verbindungen erzeugt werden.

Die Kontaktstelle des ersten und/oder zweiten Bauteils kann beispielsweise eine Kontaktfläche sein. Die Kontaktstelle umfasst in der Regel eine Metallfläche, beispielsweise ein Metallbeschichtung. Die Kontaktstelle kann beispielsweise Kupfer enthalten. Beispielsweise kann die Kontaktstelle dasselbe Metall enthalten wie die Einzeladern der Litze. Beim Laserschweißen entsteht in der Regel eine direkte stoffschlüssige Verbindung zwischen den Einzeladern der Litze und der Kontaktstelle. Hierbei kann beispielsweise eine stoffschlüssige Verbindung zwischen dem Metall der Kotaktfläche und dem Metall der Einzeladern der Litze hergestellt werden. Ein Lotmaterial, beispielsweise Lötzinn, ist nicht notwendigerweise zwischen den Einzeladern und der Kontaktstelle angeordnet. Es kann in anderen Ausführungen, die insbesondere ein Laserverlöten der Litze mit der Kontaktstelle des ersten und/oder zweiten Bauteils vorsehen, ein Lotmaterial zwischen den Einzeladern und der Kontaktstelle angeordnet sein.

Es kann beispielsweise vorgesehen sein, dass die Litze, insbesondere für das Laserverlöten und beispielsweise bereits vor dem Verbinden mit der Kontaktstelle des ersten und/oder zweiten Bauteils ein niedriger-schmelzendes Metall als das Metall der Einzeladern, insbesondere ein Lotmaterial, beispielsweise Lötzinn, aufweist. Es kann vorgesehen sein, dass die metallischen Einzeladern jeweils mit Lotmaterial umhüllt sind oder dass das Lotmaterial mehrere Einzeladern flächig überdeckt. Beispielsweise kann das Lotmaterial flächig auf den Einzeladern aufgebracht sein und insbesondere teilweise oder vollständig die Ober- und/oder Unterseite der Litze bedecken. Beispielsweise kann die Litze Einzeladern aus Kupfer aufweisen, die jeweils mit Lötzinn ummantelt sind. In anderen Ausführungen kann das elektronische Bauelement eine Lotfolie aufweisen. Die Lotfolie kann zwischen der Litze und der Kontaktstelle angeordnet sein oder angeordnet werden vor dem Verbinden der Litze mit der Kontaktstelle.

Die Litze kann biegsam oder flexibel sein. Hierdurch kann bei hinreichend großem Leitungsquerschnitt eine Robustheit der Verbindung verbessert werden. Es kann insbesondere vorgesehen sein, dass das erste Bauteil und das zweite Bauteil über die Litze beweglich miteinander verbunden sind. Die Litze kann hierbei so ausgebildet sein, dass diese Relativbewegungen zwischen dem ersten und dem zweiten Bauteil zulässt, insbesondere ohne dass die Verbindung zwischen dem ersten und zweiten Bauteil gelöst wird. Eine derartige Ausführung ist insbesondere vorteilhaft, wenn bei der Anwendung des elektronischen Bauelements Relativbewegungen zwischen dem ersten Bauteil und dem zweiten Bauteil auftreten, beispielsweise in Form von Vibrationen, die bei der Verwendung des elektronischen Bauelements in einem Fahrzeug auftreten können.

In einigen Ausführungen kann die Litze an mehreren Stellen mit der Kontaktstelle des ersten Bauteils laserverschweißt und/oder laserverlötet sein. Zusätzlich oder alternativ kann die Litze an mehreren Stellen mit der Kontaktstelle des zweiten Bauteils laserverschweißt und/oder laserverlötet sein. Beispielsweise können zumindest zwei dieser Stellen vorgesehen sein, sodass die Litze zuverlässig mit dem ersten bzw. zweiten Bauteil verbunden ist.

In einigen Ausführungen weist das zweite Bauteil einen für Laserlicht eines Lasers transparenten Kanal auf. Die Litze kann über oder unter dem Kanal des zweiten Bauteils angeordnet sein und kann den Kanal überdecken. Es kann hierbei vorgesehen sein, dass die Litze an zumindest zwei Stellen mit der Kontaktstelle des zweiten Bauteils verbunden, insbesondere laserverschweißt und/oder laserverlötet ist, und dass der Kanal zwischen diesen beiden Stellen angeordnet ist. Auf diese Weise kann die Litze beidseitig des Kanals mit dem zweiten Bauteil verbunden sein. Der Kanal kann eingerichtet sein das Laserlicht für das Laserverschweißen bzw. Laserverlöten der Litze mit der Kontaktstelle des ersten Bauteils durch das zweite Bauteil so hindurchtreten zu lassen, dass das Laserlicht auf die Litze trifft. Bei der Herstellung des elektronischen Bauelements kann die Litze über oder unter dem Kanal des zweiten Bauteils so angeordnet werden, dass die Litze den Kanal überdeckt, insbesondere vor dem Verbinden der Litze mit der Kontaktstelle des zweiten Bauteils. Anschließend wird die Litze in der Regel mit dem zweiten Bauteil verbunden, insbesondere laserverschweißt oder laserverlötet. In einem weiteren Schritt kann das Laserverschweißen bzw. Laserverlöten der Litze mit der Kontaktstelle des ersten Bauteils durch Bestrahlung der Litze mit einem Laser so erfolgen, dass der Laserstrahl durch den Kanal des zweiten Bauteils hindurch tritt. In typischen Ausführungen ist der für Laserlicht des Lasers transparente Kanal des zweiten Bauteils eine Durchgangsöffnung im zweiten Bauteil. Beispielsweise kann der Kanal als Bohrung im zweiten Bauteil ausgebildet sein.

Es kann in einigen Ausführungen, insbesondere dann, wenn das erste Bauteil ein Leistungshalbleiter ist, vorgesehen sein, dass das erste Bauteil thermisch leitfähig mit einem Kühler verbunden ist. In einigen Ausführungen ist das erste Bauteil für eine verbesserte Wärmeabfuhr von dem Leistungshalbleiter auf dem Kühler angeordnet. Beispielsweise kann das erste Bauteil auf den Kühler aufgesintert sein. Auf diese Weise kann eine hinreichende Wärmeabfuhr gewährleistet werden.

In typischen Ausführungen ist das erste Bauteil und/oder das zweite Bauteil eine Leiterplatte, insbesondere ein PCB. Die Leiterplatte weist in der Regel isolierendes Material und Leiterbahnen auf. Die Leiterbahnen können in verschiedenen Lagen in der Leiterplatte ausgebildet werden. Die Leiterplatte kann beispielsweise elektrisch mit weiteren Bauteilen verbunden sein, beispielsweise mit einem Zwischenkreiskondensator. Es kann auch vorgesehen sein, dass das erste Bauteil und/oder zweite Bauteil eine Verschienung ist. Die Verschienung kann gegeneinander isolierte Bleche, insbesondere Metallbleche, beispielsweise Kupferbleche, aufweisen. In weiteren Ausführungen ist das erste Bauteil und/oder das zweite Bauteil beispielsweise ein Keramik-Substrat oder eine Kupferverschienung.

Es kann gemäß einer Ausführungsform vorgesehen sein, dass das erste Bauteil ein Halbleiterchip ist. Das erste Bauteil kann zudem auf einer Oberseite des zweiten Bauteils angeordnet ist. Hierbei können das erste und zweite Bauteil so zueinander angeordnet sein, dass das zweite Bauteil einen lateralen Überstand gegenüber dem ersten Bauteil aufweist. Die Kontaktstelle des ersten Bauteils kann auf einer Oberseite des ersten Bauteils angeordnet sein. Ferner kann die Kontaktstelle des zweiten Bauteils auf der Oberseite des zweiten Bauteils neben dem ersten Bauteil angeordnet sein.

In einigen Ausführungen ist das erste Bauteil ein Anschlussterminal, insbesondere ein Schraubterminal. Das zweite Bauteil, insbesondere wenn dieses als Leiterplatte ausgeführt ist, kann in das Anschlussterminal eingelassen sein.

In weiteren Ausführung ist oder umfasst das erste Bauteil eine Motorwicklung oder eine Zwischenkreisverschienung.

Oben oder unten in Bezug auf das elektronische Bauelement genannte Merkmale sind auf das Verfahren zur Herstellung des elektronischen Bauelements übertragbar und umgekehrt.

Ausführungsbeispiele werden nachfolgend anhand der Abbildungen beschrieben. Es zeigen
- Fig. 1: eine schematische Querschnittsansicht eines elektronischen Bauelements,
- Fig. 2: Litzen, die mit einer Unterseite einer Leiterplatte laserverschweißt oder laserverlötet sind,
- Fig. 3: einen Leistungshalbleiter in einer Umverpackung (Prepackage) auf einem Kühlkörper,
- Fig. 4: eine Oberseite einer Leiterplatte,
- Fig. 5: ein elektronisches Bauelement gemäß einer weiteren Ausführung und
- Fig. 6: ein elektronisches Bauelement gemäß einer weiteren Ausführung.

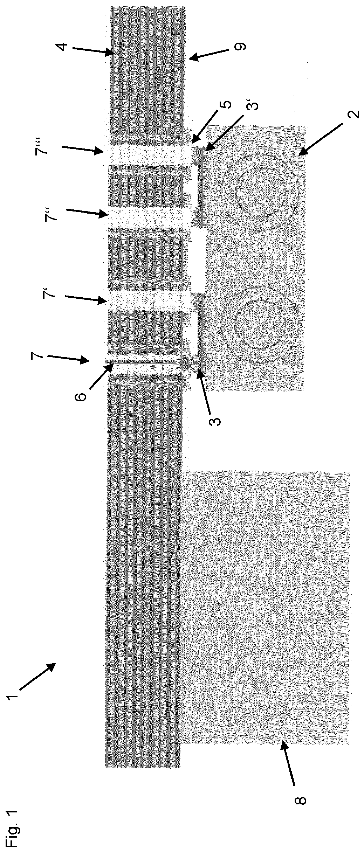

Figur 1 zeigt eine schematische Querschnittsansicht eines elektronischen Bauelements 1, das ein Leistungsmodul bildet. Das elektronische Bauelement umfasst einen Kühler 2, auf dessen Oberfläche mehrere erste Bauteile in Form von Leistungshalbleitern 3, 3' aufgesintert sind. Der Kühler 2 ist thermisch leitfähig mit den Leistungshalbleitern 3, 3' verbunden und eingerichtet, im Betrieb von den Leistungshalbleitern 3, 3' erzeugte Abwärme abzuführen. Mit Kontaktstellen auf Oberflächen der Leistungshalbleiter 3, 3' ist ein zweites Bauteil in Form einer Leiterplatte 4, beispielsweise ein PCB mit einer Vielzahl von Leiterbahnen, elektrisch leitfähig und beweglich verbunden.

Die Leiterplatte 4 ist mit den Leistungshalbleitern 3, 3' über biegsame Litzen verbunden, die einerseits eine elektrische Verbindung zwischen den leiterbahnen der Leiterplatte 4 und den Leistungshalbleitern 3, 3' und andererseits eine mechanisch bewegliche Verbindung zwischen der Leiterplatte 4 und den Leistungshalbleitern 3, 3' erzeugen. Eine der Litzen ist in der Fig. 1 beispielhaft mit dem Bezugszeichen 5 gekennzeichnet. Die Litzen sind in der Regel aus mehreren Kupfer-Einzeldrähten geflochtene und gewalzte Flachbänder. Es kann vorgesehen sein, dass die einzelnen Einzeldrähte oder mehrere Einzeldrähte mit einem Lotmaterial, beispielsweise Zinn umgeben sind. Die Verschweißung kann entweder direkt erfolgen oder mit einer Lotschicht dazwischen, vergleichbar einer Lötung mit lokalem Wärmeeintrag. Der Einsatz einer flexiblen Litze gewährleistet eine mechanische Entkopplung, die aus Gründen der mechanischen Zuverlässigkeit und Lebensdauer vorteilhaft ist.

Zur Verbindung der Leiterplatte mit den Leistungshalbleitern 3, 3' werden die Litzen 5 mit Kontaktstellen an den Oberseiten der Leistungshalbleiter 3, 3' und an der Unterseite 9 der Leiterplatte 4 laserverschweißt oder laserverlötet, wobei auch Mischformen dieser Verbindungsarten möglich sind. Die Fig. 1 illustriert einen Schritt des Verbindens der Litzen 5 mit den Leistungshalbleitern 3, 3', nachdem die Litzen 5 bereits mit der Leiterplatte 4 laserverschweißt oder laserverlötet wurden. Damit die Litzen 5 im Bereich der Kontaktstellen der Leistungshalbleiter 3, 3' für das Laserverschweißen bzw. Laserverlöten für die Laserstrahlung, schematisch gekennzeichnet mit dem Bezugszeichen 6, zugänglich sind, weist die Leiterplatte 4 für die Laserstrahlung transparente Kanäle in Form mehrerer Bohrungen 7, 7', 7", 7‴ auf. Die Bohrungen 7, 7', 7", 7‴ sind oberhalb der Kontaktstellen der Leistungshalbleiter 3, 3' angeordnet, mit denen die Litzen 5 verbunden werden. Auf die beschriebene Weise kann eine zuverlässige elektrische und mechanisch bewegliche Verbindung zwischen den Leistungshalbleitern 3, 3' und der Leiterplatte 4 erzeugt werden, die den Fluss hoher Ströme erlaubt. Die Leiterplatte 4 ist in dem gezeigten Beispiel ferner elektrisch leitfähig und mechanisch mit einem Zwischenkreiskondensator 8 verbunden.

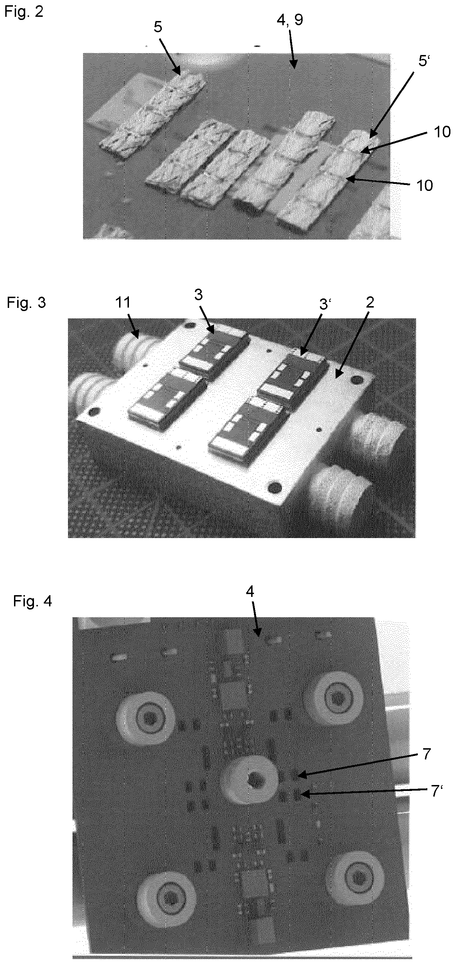

Figur 2 zeigt eine Vielzahl von Litzen, von denen zwei mit den Bezugszeichen 5 und 5' gekennzeichnet sind. Wiederkehrende Merkmale sind in dieser und in den folgenden Abbildungen mit den gleichen Bezugszeichen versehen. Die Litzen 5, 5' sind in der gezeigten Darstellung bereits mit der Unterseite 9 der Leiterplatte 4 laserverschweißt oder laserverlötet, jedoch noch nicht mit den Leistungshalbleitern 3, 3'. Zum Verbinden der Litzen 5, 5' mit der Unterseite 9 der Leiterplatte 4 werden die Litzen 5, 5' auf die Unterseite 9 der Leiterplatte 4 aufgelegt, so dass je eine der Litzen 5, 5' eine der Bohrungen 7, 7', 7", 7‴ überdeckt. Anschließend wird ein Laser mit geringer Spotgröße quer zu einer Richtung einer länglichen Ausdehnung der Litzen 5, 5' bewegt, derart, dass die Litzen 5, 5' an mehreren Stellen, insbesondere beidseitig der zugehörigen Bohrung 7, 7', 7", 7‴, entlang von Schweiß- oder Lötlinien 10, 10' mit den Kontaktstellen auf der Unterseite 9 der Leiterplatte verschweißt bzw. verlötet sind.

Figur 3 zeigt eine Oberfläche des Kühlers 2, auf den die Leistungshalbleiter 3, 3' aufgesintert sind. Die Leistungshalbleiter sind hierbei vorverpackt in einem Prepackage. In der dargestellten Anordnung sind die Leistungshalbleiter 3 noch nicht mit den Litzen 5, 5' oder mit der Leiterplatte 4 verbunden. Der Kühler 2 weist vier Anschlüsse zur Durchströmung des Kühlers 2 mit einem Kühlfluid auf, von denen einer mit dem Bezugszeichen 11 gekennzeichnet ist. Figur 4 illustriert eine Oberseite der Leiterplatte 4, auf der die durchgehenden Bohrungen zum Durchtritt des Laserstrahls bei der Verbindung der Litzen 5, 5' mit den Leistungshalbleitern 3, 3' erkennbar sind. Gekennzeichnet sind beispielhaft Bohrungen mit den Bezugszeichen 7, und 7'.

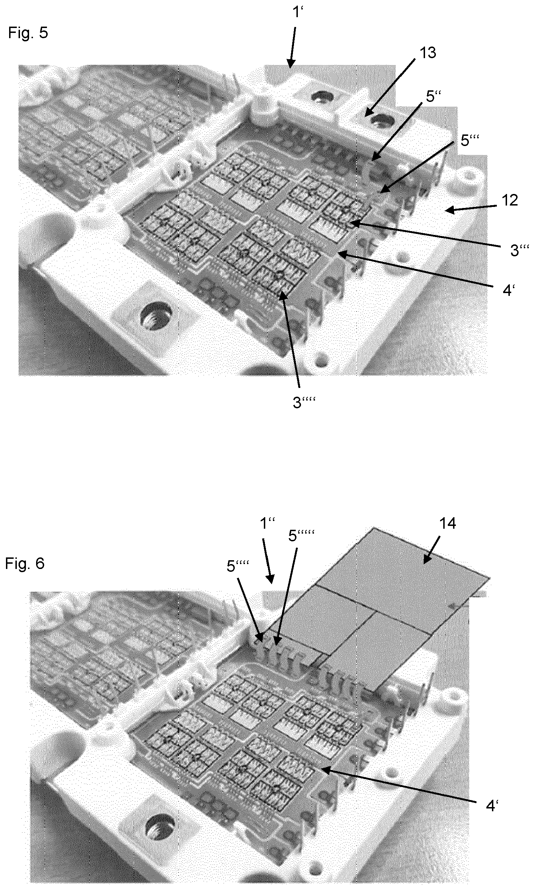

Figuren 5 und 6 illustrieren jeweils eine weitere Ausgestaltung des elektronischen Bauelements 1', 1". Bei der Ausführungen gemäß Fig. 5 ist ein Keramik-Substrat 4' in einen Rahmen 12 mit einem Schraubterminal 13 eingelassen. Der Rahmen 12 liegt auf einem Kupferkühlkörper auf, auf den das Keramik-Substrat 4' aufgelötet ist. Leistungshalbleiter 3"', 3"" sind auf einer Oberseite des Keramik-Substrats 4' angeordnet. Eine Litze 5" der oben beschriebenen Art ist mit dem Keramik-Substrat 4' laserverschweißt oder laserverlötet und mit dem Schraubterminal laserverschweißt oder laserverlötet und verbindet das Keramik-Substrat 4' auf diese Weise elektrisch mit dem Schraubterminal 13. Derartige Verbindungen aus dem Stand der Technik beruhen in der Regel auf einer Ultraschallverschweißung. Eine weitere Litze 5‴ ist als Ersatz für bekannte Bonddrähte mit einer lötbaren Kontaktstelle auf der Oberfläche des Leistungshalbleiters 3‴ und einer Kontaktstelle auf der Oberseite des Keramik-Substrats 4', oder laserverlötet oder beispielsweise mit einer Kontaktstelle aus Kupfer auf der Oberfläche des Leistungshalbleiters 3‴ laserverschweißt, sodass durch die Litze 5‴ eine elektrische Verbindung zwischen dem Keramik-Substrat 4' und dem Leistungshalbeiter 3‴ hergestellt ist. In der in Fig. 6 dargestellten Ausführung wird eine Vielzahl von Litzen 5"", 5ʺ‴ der beschriebenen Art verwendet, um durch Laserverschweißen oder Laserverlöten eine elektrische und mechanische Verbindung zwischen dem Keramik-Substrat 4' und einer Zwischenkreisverschienung 14, die nicht mehr Teil des Leistungsmoduls im engeren Sinne ist, herzustellen. In anderen Ausführungen können die Litzen in der beschriebenen Weise verwendet werden, um beispielsweise eine Verbindung zwischen der Leiterplatte und einer Motorwicklung herzustellen.

Lediglich in den Ausführungsbeispielen offenbarte Merkmale der verschiedenen Ausführungsformen können miteinander kombiniert und einzeln beansprucht werden.

## Patentansprüche

1. Elektronisches Bauelement (1), umfassend ein erstes Bauteil (3) und ein zweites Bauteil (4), **gekennzeichnet durch** eine Litze (5), die mit einer Kontaktstelle des zweiten Bauteils (4) verbunden ist und mit einer Kontaktstelle des ersten Bauteils (3) laserverschweißt und/oder laserverlötet ist.

2. Elektronisches Bauelement (1) nach Anspruch 1, wobei das zweite Bauteil (4) einen für Laserlicht eines Lasers transparenten Kanal (7) aufweist und die Litze (5) über oder unter dem Kanal (7) des zweiten Bauteils (4) angeordnet ist und den Kanal (7) überdeckt, wobei der Kanal (7) eingerichtet ist das Laserlicht für das Laserverschweißen bzw. Laserverlöten der Litze (5) mit der Kontaktstelle des ersten Bauteils (3) durch das zweite Bauteil (4) so hindurchtreten zu lassen, dass das Laserlicht auf die Litze (5) trifft.

3. Elektronisches Bauelement (1) nach Anspruch 2, **dadurch gekennzeichnet, dass** der für Laserlicht des Lasers transparente Kanal (7) des zweiten Bauteils (4) eine Durchgangsöffnung im zweiten Bauteil (4) ist.

4. Elektronisches Bauelement (1) nach einem der Ansprüche 2 oder 3, **dadurch gekennzeichnet, dass** die Litze (5) über oder unter dem Kanal (7) des zweiten Bauteils (4) angeordnet ist und den Kanal (7) überdeckt.

5. Elektronisches Bauelement (1) nach Anspruch 4, **dadurch gekennzeichnet, dass** die Litze (5) beidseitig des Kanals (7) mit dem zweiten Bauteil (4) verbunden ist.

6. Elektronisches Bauelement (1) nach einem der Ansprüche 1 bis 5, **dadurch gekennzeichnet, dass** die Litze (5) mit der Kontaktstelle des zweiten Bauteils (4) ebenfalls laserverschweißt oder laserverlötet ist.

7. Elektronisches Bauelement (1) nach einem der Ansprüche 1 bis 6, **dadurch gekennzeichnet, dass** das zweite Bauteil eine Leiterplatte oder eine Verschienung (4, 4'), insbesondere gegeneinander isolierte Bleche, beispielsweise Kupferbleche, aufweisend, ist.

8. Elektronisches Bauelement (1) nach einem der Ansprüche 1 bis 7, **dadurch gekennzeichnet, dass** das zweite Bauteil ein PCB mit einer Vielzahl von Leiterbahnen ist.

9. Elektronisches Bauelement (1) nach einem der Ansprüche 1 bis 8, **dadurch gekennzeichnet, dass** dieses eine Halbleiteranordnung ist, die zumindest einen Halbleiterchip umfasst.

10. Elektronisches Bauelement (1) nach einem der Ansprüche 1 bis 9, **dadurch gekennzeichnet, dass** dieses ein Leistungsmodul (1) ist.

11. Elektronisches Bauelement (1) nach einem der Ansprüche 1 bis 10, **dadurch gekennzeichnet, dass** das erste Bauteil (3, 3') ein Leistungshalbleiter ist.

12. Elektronisches Bauelement (1) nach einem der Ansprüche 1 bis 11, **dadurch gekennzeichnet, dass** die Litze (5) ein Flachband ist.

13. Elektronisches Bauelement (1) nach einem der Ansprüche 1 bis 12, **dadurch gekennzeichnet, dass** das erste Bauteil (3) und das zweite Bauteil (4) über die Litze (5) beweglich miteinander verbunden sind.

14. Verfahren zur Herstellung eines elektronischen Bauelements (1), bei dem ein erstes Bauteil (3) des elektronischen Bauelements (1) mit einem zweiten Bauteil (4) des elektronischen Bauelements (1) verbunden wird, umfassend folgende Schritte:
- Bereitstellen des ersten Bauteils (3) und des zweiten Bauteils (4),
- Bereitstellen einer Litze (5),
- Verbinden der Litze (5) mit einer Kontaktstelle des zweiten Bauteils (4),
- Laserverschweißen und/oder Laserverlöten der Litze (5) mit einer Kontaktstelle des ersten Bauteils (3) durch Bestrahlung der Litze (5) mit einem Laser, derart, dass eine elektrisch leitfähige Verbindung zwischen der Litze (5) und dem ersten Bauteil (3) erzeugt wird.

15. Verfahren nach Anspruch 14, wobei das zweite Bauteil (4) einen für Laserlicht des Lasers transparenten Kanal (7) aufweist, umfassend folgenden Schritt:
- Anordnen der Litze (5) über oder unter dem Kanal (7) des zweiten Bauteils (4) vor dem Verbinden der Litze (5) mit der Kontaktstelle des zweiten Bauteils (4), so dass die Litze (5) den Kanal überdeckt, wobei das Laserverschweißen bzw. Laserverlöten der Litze (5) mit der Kontaktstelle des ersten Bauteils (3) durch Bestrahlung der Litze (5) mit einem Laser so erfolgt, dass der Laserstrahl durch den Kanal (7) des zweiten Bauteils (4) hindurch tritt.
